# EUROPEAN PATENT SPECIFICATION

(11) **EP 2 824 471 B1**
(45) Date of publication and mention of the grant of the patent: **06.03.2019**
(21) Application number: 13003492.9
(22) Date of filing: 10.07.2013
(51) Int. Cl.: G01R 33/28, G01R 33/30, G01R 33/48, G01N 24/08, G02B 21/00, G02B 21/33

(54) **MR-compatible Microscope**
MR-kompatibles Mikroskop
Microscope compatible avec la résonance magnétique

(43) Date of publication of application: 14.01.2015
(73) Proprietor: Baden-Württemberg Stiftung gGmbH, 70174 Stuttgart (DE)
(72) Inventor: Wapler, Matthias Christian, 79117 Freiburg (DE); Wallrabe, Ulrike, 76228 Karlsruhe (DE); Zaitsev, Maxim, 79117 Freiburg (DE); von Elverfeldt, Dominik, 79100 Freiburg (DE)
(74) Representative: Müller-Boré & Partner Patentanwälte PartG mbB

(56) References cited:
- JP-A- S6 385 437
- JP-A- 2001 188 175
- JP-A- 2003 126 061
- US-A- 5 805 335
- US-A1- 2007 173 718
- SCHNEIDER F ET AL: "An adaptive objective for optical motion correction in MRI", OPTICAL MEMS AND NANOPHOTONICS (OPT MEMS), 2010 INTERNATIONAL CONFERENCE ON, IEEE, PISCATAWAY, NJ, USA, 9 August 2010 (2010-08-09), pages 189-190, XP031838363, ISBN: 978-1-4244-8926-8
- DEMYANENKON A.V. ET AL.: "Dual-Mode Optical-MR Microscopy with Iniplanar Gradient Coils", PROCEEDINGS OF THE INTERNATIONAL SOCIETY FOR MAGNETIC RESONANCE IN MEDICINE, 19TH ANNUAL MEETING PROCEEDINGS, 9 May 2011 (2011-05-09), page 38, XP040620670,
- LIN Y. ET AL.: "An Optical Imaging System for Window Chambers in MRI System", PROCEEDINGS OF THE SPIE - THE INTERNATIONAL SOCIETY FOR OPTICAL ENGINEERING - CONFERENCE: DESIGN AND QUALTY FOR BIOMEDICAL TECHNOLOGIES, vol. 6849, 21 January 2008 (2008-01-21), pages 684907-1-684907-5, XP040432772, USA

## Description

The present invention provides an MR-compatible optical microscope that can be used to optically observe a sample inside a magnetic resonance (MR) device, such as a magnetic resonance imaging (MRI) scanner. It particularly allows to microscopically observe the sample in a direction perpendicular to a direction of the magnetic field inside a magnetic coil of a MR device.

In conventional approaches, magnetic resonance measurements and optical microscopy are carried out in separate devices and one after the other. Although in-situ optical microscopy of samples located in an MRI scanner, preferably even during an MRI scan would be highly desirable, there have been substantial problems in realising this. On the one hand, the limited space inside the magnet of an MR device (also called NMR device, nuclear magnetic resonance device), e.g. a magnetic coil of an MRI scanner, as well as the high magnetic field prevents arranging and operating a conventional microscope. On the other hand, every additional material near the sample in an MRI scanner, such as parts of a microscope (lenses, mirrors, etc.), may significantly affect the magnetic field strength at the position of the sample and may, therefore, distort the MRI scan or any other magnetic resonance (spectroscopic) measurement. Thus, it was believed that a high resolution optical microscopy would be incompatible with magnetic resonance imaging or magnetic resonance spectroscopy.

JP S63 85437A discloses an MRI microscope for observing a sample in the same state at the same time by displaying an optical image and an MRI image.

SCHNEIDER F ET AL: "An adaptive objective for optical motion correction in MRI", OPTICAL MEMS AND NANOPHOTONICS (OPT MEMS), 2010 INTERNATIONAL CONFERENCE ON, IEEE, PISCATAWAY, NJ, USA, 9 August 2010 (2010-08-09), pages 189-190 discloses an adaptive membrane lens as a part of an objective being compatible with a MR system for an optical motion tracking system to observe the movements of a patient.

DEMYANENKON A.V. ET AL.: "Dual-Mode Optical-MR Microscopy with Iniplanar Gradient Coils", PROCEEDINGS OF THE INTERNATIONAL SOCIETY FOR MAGNETIC RESONANCE IN MEDICINE, 19TH ANNUAL MEETING PROCEEDINGS, 9 May 2011 (2011-05-09), page 38 discloses a method for dual-mode optical-MR microscopy using an integrated optical microscope into MR imaging hardware.

According to the present invention, however, the problem of an in-situ high resolution optical microscopy in an MRI scanner is solved by a microscope as defined in claim 1 and a method as defined in claim 11. Preferred embodiments are defined in the dependent claims.

Accordingly, in one aspect, the present invention provides an MR-compatible (NMR-compatible) optical microscope, which is adapted for use in a magnetic resonance device, such as a magnetic resonance imaging (MRI) scanner, particularly inside a magnet coil of an MRI scanner. The microscope comprises an objective lens assembly for collecting light from a sample to be investigated within an MR magnet, wherein the objective lens assembly has a first optical axis. Moreover, the optical microscope comprises an observation optics (such as an ocular or a camera) having a second optical axis that is perpendicular to the first optical axis. In order to deflect the light from the objective lens assembly to the observation optics, the microscope comprises a light path deflection assembly, which is arranged in the optical path between the objective lens assembly and the observation optics. In particular, the light path deflection assembly deflects light leaving the objective lens assembly along the first optical axis to enter the observation optics along the second optical axis. Thus, thus the light path deflection assembly defines the optical light path between the objective lens assembly and the observation optics.

The angled or folded optical path of the MRI-compatible microscope allows a very compact design in combination with the possibility to microscopically observe a sample in a direction substantially perpendicular to the magnetic field of an MRI scanner. The observation substantially perpendicular to the magnetic field is specifically advantageous, since it allows to additionally arrange magnetic micro coils that are used in magnetic resonance microscopy for receiving radio frequency (RF) signals from the sample. Since such micro coils should be arranged perpendicular to the magnetic field, they could be provided easily in addition to the optical microscope, if the first optical axis is arranged substantially along the axis of the micro coils. On the other hand, the observation of the optical microscopic image with the observation optics having the second optical axis perpendicular to the optical axis of the objective lens, the second optical axis can be aligned with the axis of the magnet of the MRI scanner. Thereby, the observation optics is easily accessible from outside of the magnet.

For some applications and in some implementations it is specifically advantageous to extend the optical path of the microscope along the second optical axis so as to locate the observation optics at least partly outside of the magnet and/or outside the RF coil and/or gradient field of the MR device (e.g. MRI scanner). This becomes apparent when using an ocular for the observation optics, that should be accessible for a user to directly look into. However, even in the practically more relevant case of using a camera (e.g. a CCD camera) for the observation optics, it turned out to be superior to have the second optical axis being arranged parallel to the axis of the MR magnet. On the one hand, with this arrangement the camera can be at least partly positioned outside the magnet, which reduces an undesirable influence of the magnet (e.g. an RF signal used in the MRI) on the camera functionality. On the other hand, with this geometry, it is possible to shield the camera against RF signals with a metallic shielding, where this shielding has surprisingly little influence on the magnetic flux (or at least its homogeneity) at the position of the sample. This advantage can be specially achieved with the second optical axis being parallel to the axis of the MRI magnet, and thus substantially parallel to the magnetic field. The reason is that with this geometry mayor parts of a metallic shielding can be arranged such that metallic surfaces are largely parallel to the magnetic and/or RF field, as will be apparent from further explanations and examples described below. It turned out that with this geometry the influence on the magnetic field is sufficiently low.

A similar advantageous effect also leads to a sufficient reduction of the magnetic influence of the objective lens assembly at the sample position. In particular, with the first optical axis being perpendicular to the second optical axis, the surfaces of the lenses in the objective lens assembly are substantially parallel (except for their curvature) to the main magnetic field of the MRI scanner, if the second optical axis is parallel to this field. In other words, the magnetic field is substantially tangential to the lens surfaces. These surfaces are particularly critical, since they are very close to the sample. However, with the arrangement of the first optical axis perpendicular to the magnetic field, it was found that the influence of the lenses on the magnetic field at the sample position is surprisingly small and allow an optical in-situ microscopy within an MRI scanner.

This effect can be further improved by providing the objective lens assembly at least partly with material having a low magnetic susceptibility (e.g. a magnetic susceptibility close to that of water). In one particularly preferred embodiment, the objective lens assembly is provided and/or used as an immersion objective, preferably with water or an aqueous fluid or jelly or with oil as an immersion medium (also called index-matching material in the following). Thus, it is particularly preferred to provide the objective lens assembly at least partly with material having a volumetric magnetic susceptibility in the range of about -7·10⁻⁶ to about -11·10⁻⁶, preferably in the range of about -8·10⁻⁶ to about -10·10⁻⁶, more preferably in the range of about -8.5·10⁻⁶ to about -9.5·10⁻⁶. In the following the volumetric magnetic susceptibility will simply be called "magnetic susceptibility" and the values are given in units of the SI-system. These values are close to the magnetic susceptibility of water. Therefore, when using water as immersion fluid, there is only a small step in the magnetic susceptibility at the surface of the objective lens assembly. Preferably the step in the magnetic susceptibility between the sample and the immersion fluid and/or between the immersion fluid and the objective lens assembly is not larger than about 1·10⁻⁶, preferably not larger than about 0.5·10⁻⁶. This keeps the magnetic influence at the sample position small enough.

Preferably, an index-matching material (immersion fluid) is used that has a magnetic susceptibility in the range of about -7·10⁻⁶ to about -11.10⁻⁶, preferably in the range of about -8·10⁻⁶ to about -10·10⁻⁶, more preferably in the range of about -8.5·10⁻⁶ to about -9.5·10⁻⁶. Examples for suitable index-matching material are water, paraffin, ethylene glycol or polyethylene glycol. There are many immersion fluids (e.g. oils) having a magnetic susceptibility that is close enough to the susceptibility of water.

Preferably, the objective lens assembly comprises a front lens (which may be a single lens or a compound lens) having a magnetic susceptibility in the range of about -8.10⁻⁶ to about -10·10⁻⁶, more preferably in the range of about -8.5·10⁻⁶ to about - 9.5·10⁻⁶. Examples of material that may be used for the front lens is dense flint glass (e.g. lenses of the type N-SF 4, N-SF 10, N-SF 11, N-SF 14, or N-SF 57 from Schott may be applicable for this purpose).

It is further preferred that the front lens is mounted in a front member of the objective lens assembly. Preferably the front member comprises material having a magnetic susceptibility in the range of about -7·10⁻⁶ to about -11.10⁻⁶, more preferably in the range of about -8·10⁻⁶ to about -10·10⁻⁶, even more preferably in the range of about -8.5·10⁻⁶ to about -9.5·10⁻⁶. Preferably, the objective lens assembly, particularly the front member, does not contain metal and/or ferromagnetic material. Preferably, the objective lens assembly, particularly the front member, comprises plastic or is made of plastic. Examples of material that may be used for the font member are polymethylmethacrylate (PMMA), polystyrene (PS), polycarbonate (PC), polyimide, polyetheretherketone (PEEK), polyoxymethylene (POM), or polyurethane (PU).

The optical microscope is adapted to observe the sample located in an object plane of the microscope, wherein the second optical axis is not more than 20 mm, preferably not more than about 10 mm, more preferably not more than about 5 mm, most preferably not more than about 2 mm away from the object plane. With this arrangement, the optical microscope may be easily positioned within an MR magnet (e.g. the magnet of an MRI scanner) such that the sample is located in the centre of the magnet (isocentre), ready for a magnetic resonance measurement, while simultaneously (or without changing the object position) the object can be observed with the optical microscope, where the second optical axis may be arranged along the centre axis of the MR magnet. With this geometry the influence of the optical microscope on the homogeneity of the magnetic field at the sample position turned out to be very small. Thereby, the quality of the MRI images and the MR spectroscopic measurements is remarkably high, despite the presence of the optical microscope. Furthermore, when using a metallic shielding for a camera as part of the observation optics, the central position of the second optical axis along
the magnet axis significantly reduces vibrations of the shielding caused by magnetic induction.

In a preferred embodiment, the objective lens assembly comprises an adaptive lens. Preferably, the optical power of the adaptive lens is variable via a piezo actuator and/or via electro-wetting and/or hydraulically. The adaptive lens may contain a fluid enclosed by a membrane (such as a PDMS membrane). The curvature of the membrane and thus the power of the adaptive lens may be controlled by a piezo actuator. Preferably the adaptive lens is provided at the back end of the objective lens assembly. This results in an efficient tradeoff between positioning the adaptive lens (possibly including metallic and/or magnetic materials) sufficiently far away from the sample position in order to reduce its influence on the magnetic field distribution at the sample position, and positioning the adaptive lens close enough to the sample in the optical path in order to achieve the desired range of variation of the focal position. When moving the adaptive lens further away from the sample position, a variation of the power of the adaptive lens has less influence on the focal position.

Preferably, the light path deflection assembly comprises one or more reflection prisms that effect the light deflection by total reflection. This ensures a very high degree of reflection with low loss, while avoiding any metallic layer that could affect the homogeneity of the magnetic field at the sample position. In another embodiment, however, also metallic mirrors may be used, at least if the metallic coating is not considerably thicker than about several hundreds of nm. In yet another embodiment, dielectric mirrors may be used.

In one preferred embodiment the observation optics may comprise an ocular for directly observing the sample. In view of a convenient handling and in view of post-processing and electronic archiving of the results of a microscopic investigation, it is practically more useful to apply a camera instead of directly looking into the microscope. Therefore, in another preferred embodiment, the observation optics comprise a (digital) camera. Typically electronic cameras are rather sensitive to magnetic field and particularly to RF fields and gradient fields typical applied in MRI scanner. Therefore, it is preferred that a metallic shielding surrounds the camera at least partly. However, in order to allow the camera to observe the microscope light, an opening is required in the RF shielding around the optical path of the microscope. In order to avoid the RF fields to penetrate the opening of the shielding and to affect the camera inside, it is preferred to provide the metallic shielding with a tube portion extending substantially along the second optical axis. Preferably the tube portion has an aspect ratio (i.e. the ratio between its length along the second optical axis and its diameter perpendicular to the second optical axis) of at least about 2, more preferably at least about 3, even more preferably at least about 4. The higher the aspect ratio, the less RF signal can penetrate to the camera, while the light from the objective lens assemble can still reach the camera along the optical path (e.g. along the second optical axis). The tube portion of the shielding may also accommodate at least part of the camera optics (e.g. an observation lens assembly).

Preferably, the microscope comprises a front illumination unit for illuminating the sample through the objective lens assembly. This illumination light may be coupled into the optical path of the objective lens assembly by means of a beam splitter in order to illuminate the sample on its front side (or upper side). Alternatively or additionally, the microscope may comprise a back illumination unit for illuminating the sample from the rear side, i.e. from the side opposite to the side where the objective lens assembly is provided. The front illumination unit and/or the back illumination unit may utilize LEDs and/or optical fibers as (direct or indirect) light sources.

In another aspect, the present invention provides a method of optical microscopy inside a MRI scanner comprising
- providing an optical microscope with an objective lens assembly for collecting light from a sample to be investigated within an MRI scanner, the objective lens assembly having a first optical axis, with observation optics having a second optical axis perpendicular to the first optical axis; and with a light path deflection assembly for deflecting light from the objective lens assembly to the observation optics; wherein the optical microscope is adapted to observe the sample located in an object plane of the microscope, wherein the second optical axis is not more than 20 mm away from the object plane; and
- arranging the optical microscope inside a magnet of the MRI scanner with the first optical axis arranged along a centre axis of the magnet, with the first optical axis substantially perpendicular to the centre axis of the magnet and with the second optical axis substantially parallel to the centre axis of the magnet, and thus substantially parallel to the magnetic field of the magnet.

Preferably, an index-matching material is provided to fill the gap between the sample and the objective lens assembly, wherein the index-matching material has a magnetic susceptibility in the range of about -8·10⁻⁶ to about -10·10⁻⁶, preferably in the range of about -8.5·10⁻⁶ to about -9.5·10⁻⁶. This is specifically advantageous when the sample contains water. In another aspect, it is specifically preferred, that the index-matching material and/or the material of the objective lens assembly (particularly the material of the front lens) is used such that the step in the magnetic susceptibility between the sample and the index-matching material (immersion fluid) and/or between the index-matching material and the objective lens assembly is not larger than about 1·10⁻⁶, preferably not larger than about 0.5·10⁻⁶.

Preferably, the method further comprises arranging a front lens of the objective lens assembly and an illumination front lens symmetrically on both sides of the sample with respect to an object plane of the optical microscope, wherein the sample is positioned in the object plane of the microscope.

Preferably, the method further comprises magnetically measuring the sample with the MRI scanner (e.g. taking a magnetic resonance image and/or a magnetic resonance spectrum) while the optical microscope is positioned inside of the magnet. In a further preferred embodiment an optical microscopic picture of the sample is taken while the magnetic field of the MRI scanner is turned on.

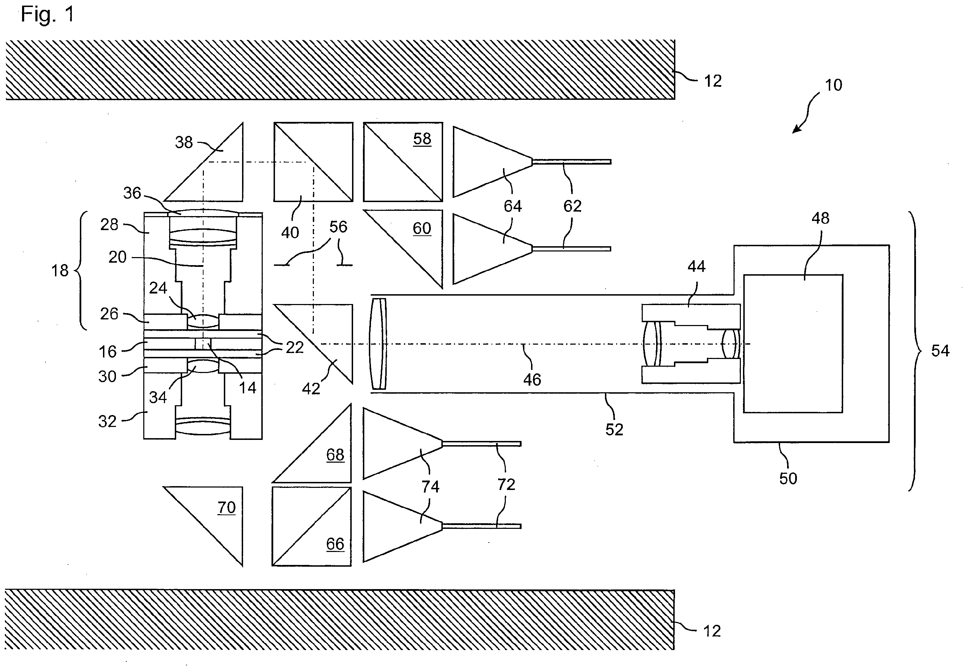

In the following, further details of the invention will be described with reference to preferred embodiments, wherein
- Fig. 1: shows a schematic cross sectional view of an optical microscope according to a preferred embodiment of the present invention arranged in a MRI magnet coil.

Fig. 1 shows a exemplary embodiment of an optical microscope 10 adapted for use in a magnetic resonance imaging (MRI) scanner. The microscope 10 is arranged within a bore of an MRI scanner. Part of an coil 12 of an MR device (e.g. the RF transmission coil of an MRI scanner) is indicated in the cross section of Fig. 1. A sample 14 is arranged in the centre of the MRI magnet for the purpose of magnetic resonance imaging and/or magnet resonance spectroscopy. The sample 14 is held by means of a sample holder 16. In the example of Fig. 1, the sample 14 may be arranged in a centre hole (or recess) of the sample holder 16. The sample holder 16 may form a microscope stage of the optical microscope 10. Thus, in a preferred embodiment the microscope stage 16 may be part of the optical microscope 10. In another embodiment, the sample holder 16 may be provided separately from the optical microscope 10. In any case, during the optical investigation, the sample 14 is arranged at a desired fixed or adjustable position relative to the optical path of the microscope 10.

Preferably, the sample holder comprises material having a magnetic susceptibility in the range of about -7·10⁻⁶ to about -11.10⁻⁶, preferably in the range of about -8·10⁻⁶ to about -10·10⁻⁶, more preferably in the range of about -8.5·10⁻⁶ to about -9.5·10⁻⁶. Examples for suitable material for the sample holder are polymethylmethacrylate (PMMA), polystyrene (PS), polycarbonate (PC), polyimide, polyetheretherketone (PEEK), polyoxymethylene (POM), or polyurethane (PU). In a preferred embodiment (not explicitly shown in Fig. 1), a micro coil may be implemented in the sample holder for receiving RF signals from the sample.

Light from the sample 14 is collected by an objective lens assembly 18 which has a first optical axis 20. In order to achieve a clear microscopic image, the sample 14 is arranged in the object plane of the microscope 10. The object plane preferably is a plane shortly in front of the objective lens assembly 18 and perpendicular to the first optical axis 20. Focusing to a desired region of interest may be achieved by varying the distance between the sample 14 and the objective lens assembly 18 (preferably at least as long as the gap between the sample and the objective lens assembly remains filled with an immersion fluid as described later on) or by varying the focal length of the objective lens assembly 18, for example. A specifically preferred implementation for varying the focal length of the objective lens assembly 18 will be described in more detail further below. It is particularly preferred that the object plane is arranged along a centre axis of the MRI magnet coil, i.e. the centre axis of the MRI magnet coil lies within the object plane. Moreover, it is particularly preferred that the first optical axis 20 is substantially perpendicular to the centre axis of the magnet coil. It has been found by the inventors that the undesired distortion of the magnetic field by the optical microscope at the position of the sample is rather low with this arrangement. This effect may be understood with many of the relevant optical interfaces (such as lens surfaces) near the sample 14 being parallel to the magnetic flux, which largely conserves the direction and magnitude of the magnetic flux at the position of the sample 14.

In the example of Fig. 1 the objective lens assembly 18 is provided as an immersion objective, such as a water-immersion objective. Although the present invention is not limited to the use of immersion objectives, an immersion-objective is advantageous for its greater resolution at high magnification as compared to an objective lens used in air. In the example of Fig. 1 the objective lens assembly 18 is used with an index-matching material 22 filling the gap between the objective lens assembly 18 and the sample 14. In a preferred embodiment the index-matching material 22 is formed as a water film or as an aqueous jelly or as an oil, for example. The refractive index of the index-matching material 22 is higher than that of air (preferably close to the refractive index of water) allowing the objective lens assembly 18 to have a larger numerical aperture. Light is transmitted from the sample 14 to an outer face of a front lens 24 (which may be a single lens or a compound lens, such as a combination of two or more lenses) of the objective lens assembly 18 with minimal refraction. Preferably, the front lens 24 has a magnetic susceptibility in the range of about -8·10⁻⁶ to about -10·10⁻⁶, more preferably in the range of about -8.5·10⁻⁶ to about -9.5·10⁻⁶. An example of a material that may be used for the front lens 24 is dense flint glass (e.g. lenses of the type N-SF 4, N-SF 10, N-SF 11, N-SF 14, or N-SF 57 from Schott may be applied for this purpose).

A further significant advantage of using an immersion fluid is the continuous transition of the magnetic susceptibility from the sample 14 through the index-matching material 22 to the front lens 24. Preferably, the magnetic susceptibility of the index matching material 22 and/or the front lens 24 is close to the magnetic susceptibility of water, e.g. in the range of about -8·10⁻⁶ to about -10·10⁻⁶, more preferably in the range of about -8.5·10⁻⁶ to about -9.5·10⁻⁶, i.e. not more than about 10%, preferably not more than about 5% away from the magnetic susceptibility of water.

The front lens 24 is held by an objective housing. In particular, as exemplarily demonstrated in Fig. 1, the front lens 24 may be held by a front member 26 of the objective housing. While in one embodiment the front member 26 may be provided integrally with a main body 28 of the objective housing, it is advantageous in another preferred embodiment to provide the front member 26 as a separate or separable component, which can be separated from the main body 28. The separability of the front member 26 (including the front lens 24) is specifically advantageous in case of an immersion objective, since in this case the sample holder 16 (holding the sample 14) and the front member 26 (holding the front lens 24) can be prepared as a stack with the index-matching material 22 being sandwiched in between. Moreover, with a separable front member 26, it is easier to sterilize the contact surfaces of the objective lens assembly that may come into contact with the sample or with the immersion fluid. Furthermore, replacement of defect or degraded lenses is easier.

It is further preferred that the optical microscope 10 comprises a transmitted-light unit (back illumination unit) for illuminating the sample 14 from the backside, i.e. from opposite of the objective lens assembly 18. In the preferred embodiment of Fig. 1, the transmitted-light unit comprises an illumination lens assembly having a front plate 30 and a main body 32, where the front plate 30 holds an illumination front lens 34. While in one embodiment the front plate 30 and the main body 32 of the illumination lens assembly may be provided integrally with each other (i.e. as a single piece), it is advantageous in another preferred embodiment to provide the front plate 30 as a separate or separable component, which can be separated from the main body 32 of the illumination lens assembly. The separability of the front plate 30 (including the illumination front lens 34) is specifically advantageous in case of an immersion objective having a separate front member 26 as described above, since in this case the sample holder 16 (holding the sample 14), the front member 26 (holding the front lens 24), and the front plate 30 (including the illumination front lens 34) can be prepared as a stack with the index-matching material 22 being sandwiched in between. Such a separate sample preparation substantially facilitates the sample handling.

Preferably, the front plate 30 (including the illumination front lens) and the front member 26 of the objective housing (including the front lens 24 of the objective lens assembly 18 are arranged and even more preferably also structured symmetrically with respect to a symmetry plane that most preferably coincides with the object plane of the microscope in which the object 14 is positioned. With this symmetric arrangement, the least distortion of the magnetic field at the sample position is ensured. Preferably, the front plate 30 applies materials described in connection with the front member 26 and/or the sample holder 16 above. Analogously, the illumination front lens 34 may apply materials described in connection with the front lens 24 above.

In the example of Fig. 1, the objective lens assembly 18 further comprises an adaptive lens 36, which allows to control the focal length of the objective lens assembly 18, e.g. via a piezo actuator that affects the surface curvature (and thus the power) of the adaptive lens 36. This is particularly advantageous, since it allows to continuously focus on the desired optical plane without the need of varying a distance of the objective lens assembly 18 to the sample 14 and without requiring manually handling the objective lens assembly when mounted in the MRI scanner. Moreover, an optical 3D scan with a sequence of optical microscopic images at different focal length can be achieved very fast and efficiently.

In the preferred embodiment demonstrated in Fig. 1, the optical microscope 10 comprises a light path deflection assembly, which is composed of a first reflection prism 38, a second reflection prism 40, and a third reflection prism 42 causing a deflection of the microscopic light path such that light leaving the objective lens assembly 18 along the first optical axis 20 enters an observation lens assembly 44 (e.g. camera optics as part of an observation optics 54) along a second optical axis 46. The second optical axis is perpendicular to the first optical axis 20. Moreover, in this preferred embodiment the second optical axis 46 lies in the object plane of the optical microscope, which allows to position the second optical axis 46 directly in the centre of the MR magnet coil 12. With this arrangement the distortion of the magnetic field is considered to be minimal. Moreover, it allows to locate a camera 48 furthest away from the magnet coil 12, where the camera 48 (such as a CCD camera) may be protected against electro-magnetic fields, more particularly against an RF field and/or the gradient field that is typically applied in MRI scanners, by means of a metallic shielded chamber 50 in combination with its extension in the shape of a shielding tube 52 that extends substantially along the second optical axis 46 so as to avoid the penetration of the RF field into the shielded chamber 50, thereby preventing the RF field to affect the camera function. Preferably, the shielding tube 52 accommodates the observation lens assembly at least partly.

In the embodiment of Fig. 1 an aperture 56 is provided in the optical path between the second reflection prism 40 and the third reflection prism 42. The second reflection prism 40 is provided as a part of a beam splitter in order to allow illumination light from a front illumination unit to be coupled into the light path of the microscope. In particular, the front illumination unit may comprise another beam splitter 58, another reflection prism 60 as well as two light delivering elements 62 (such as optical fibers) and two optical components 64 for widening the light beam received from the light delivering elements 62. One of the light delivering elements 62 may be provided for bright field illumination and the other one for dark field illumination. In an analogous manner, the back illumination unit may comprise another beam splitters 66 and two further reflection prisms 68, 70. Preferably, one of the reflection prisms 70 may be arranged substantially symmetric to the first reflection prism 38 with respect to the object plane. Moreover, the back illumination unit may further comprise two light delivering elements 72 (such as optical fibers) and two optical components 74 for widening the light beam analogous to the front illumination unit.

### List of Reference Numerals

- 10: optical microscope
- 12: MR magnet
- 14: sample (specimen)
- 16: sample holder, microscope stage
- 18: objective lens assembly
- 20: first optical axis
- 22: index matching material
- 24: front lens
- 26: front member of the objective housing
- 28: main body of the objective housing
- 30: front plate of an illumination lens assembly
- 32: main body of the illumination lens assembly
- 34: illumination front lens
- 36: adaptive lens
- 38: (first) reflection prism
- 40: (first) beam splitter, (second) reflection prism
- 42: (third) reflection prism
- 44: observation lens assembly
- 46: second optical axis
- 48: CCD camera
- 50: shielded chamber
- 52: shielding tube (tube portion)
- 54: observation optics
- 56: aperture
- 58: beam splitter
- 60: reflection prism
- 62: optical fibers
- 64: optical components
- 66: beam splitter
- 68: reflection prism
- 70: reflection prism
- 72: optical fibers
- 74: optical components

## Claims

1. Optical microscope (10) for use in a magnetic resonance imaging (MRI) scanner, the microscope comprising:
- an objective lens assembly (18) for collecting light from a sample (14) to be investigated within an MRI scanner, the objective lens assembly (18) having a first optical axis (20);
- observation optics (54) having a second optical axis (46) perpendicular to the first optical axis (20);
- a light path deflection assembly (38, 40, 42) for deflecting light from the objective lens assembly to the observation optics (54);
wherein the optical microscope (10) is adapted to observe the sample (14) located in an object plane of the microscope (10), wherein the second optical axis (46) is not more than 20 mm away from the object plane.

2. Optical microscope according to claim 1, wherein the objective lens assembly (18) comprises a front lens (24) having a magnetic susceptibility in the range of about -8·10⁻⁶ to about -10·10⁻⁶, preferably in the range of about -8.5·10⁻⁶ to about -9.5·10⁻⁶.

3. Optical microscope according to claim 2, wherein the front lens (24) is mounted in a front member (26) of the objective lens assembly (18), wherein the front member (26) comprises material having a magnetic susceptibility in the range of about -8·10⁻⁶ to about -10·10⁻⁶, more preferably in the range of about -8.5·10⁻⁶ to about -9.5·10⁻⁶.

4. Optical microscope (10) according to any one of the preceding claims, wherein the objective lens assembly (18) comprises an adaptive lens (36), wherein the optic power of the adaptive lens (36) is variable via a piezo actuator.

5. Optical microscope according to any one of the preceding claims, wherein the light path deflection assembly comprises one or more reflection prisms (38, 40, 42) that effect the light deflection by total reflection, wherein the one or more reflection prisms (38, 40, 42) preferably comprise a first reflection prism (38), a second reflection prism (40) and a third reflection prism (42).

6. Optical microscope according to any one of the preceding claims, wherein the observation optics (54) comprise an ocular.

7. Optical microscope according to any one of the preceding claims, wherein the observation optics (54) comprise a camera (48) and a metallic shielding (50, 52) surrounding the camera.

8. Optical microscope according to claim 7, wherein the metallic shielding comprises a tube portion (52) extending substantially along the second optical axis (46), wherein the tube portion (52) preferably accommodates the observation optics (54) at least partially.

9. Optical microscope according to any one of the preceding claims, further comprising a front illumination unit for illuminating the sample through the objective lens assembly (18) and/or a back illumination unit for illuminating the sample from the rear side.

10. Optical microscope according to any one of the preceding claims, wherein a micro coil is implemented in a sample holder and wherein the micro coil and/or the sample holder (16) preferably are/is adapted to receive RF signals from the sample (14).

11. A method of optical microscopy inside a MRI scanner comprising
- providing an optical microscope (10) with an objective lens assembly (18) for collecting light from a sample (14) to be investigated within an MRI scanner, the objective lens assembly (18) having a first optical axis (20), with observation optics (54) having a second optical axis (46) perpendicular to the first optical axis (20); with a light path deflection assembly (38, 40, 42) for deflecting light from the objective lens assembly to the observation optics (54); wherein the optical microscope (10) is adapted to observe the sample (14) located in an object plane of the microscope (10), wherein the second optical axis (46) is not more than 20 mm away from the object plane; and
- arranging the optical microscope inside a magnet of the MRI scanner with the object plane arranged along a centre axis of the magnet, with the first optical axis substantially perpendicular to the centre axis of the magnet and with the second optical axis substantially parallel to the centre axis of the magnet, and thus substantially parallel to the magnetic field of the magnet.

12. Method accordingly to claim 11, wherein an index-matching material is provided to fill the gap between the sample and the objective lens assembly, wherein the index-matching material has a magnetic susceptibility deviates from a magnetic susceptibility of the sample by not more than about 1·10⁻⁶, preferably not more than about 0.5·10⁻⁶.

13. Method according to claim 11 or 12, further comprising arranging a front lens of the objective lens assembly (18) and an illumination front lens (34) symmetrically on both sides of the sample with respect to an object plane of the optical microscope (10).

14. Method according to any one of the claims 11 to 13, further comprising magnetically measuring the sample with the MRI scanner while the optical microscope is positioned inside of the magnet.

15. Method according to any one of the claims 11 to 14, taking an optical microscopic picture of the sample while the magnetic field of the MRI scanner is turned on, preferably during an MR measurement.

## Patentansprüche

1. Ein optisches Mikroskop (10) zur Verwendung in einem Magnetresonanztomographen (MRT), wobei das Mikroskop Folgendes umfasst:
eine Objektivlinsen-Anordnung (18) zum Sammeln von Licht aus einer innerhalb eines MRT-Scanners zu untersuchenden Probe (14), wobei die Objektivlinsen-Anordnung (18) eine erste optische Achse (20) aufweist;
Beobachtungsoptik (54) mit einer zweiten optischen Achse (46) senkrecht zur ersten optischen Achse (20);
eine Lichtweg-Ablenkanordnung (38, 40, 42) zum Umlenken von Licht ausgehend von der Objektivlinsen-Anordnung zur Beobachtungsoptik (54);
wobei das optische Mikroskop (10) angepasst ist, um die Probe (14) zu beobachten, die sich in einer Objektebene des Mikroskops (10) befindet, wobei die zweite optische Achse (46) nicht mehr als 20 mm von der Objektebene entfernt ist.

2. Das optische Mikroskop nach Anspruch 1, wobei die Objektivlinsen-Anordnung (18) eine Frontlinse (24) mit einer magnetischen Suszeptibilität im Bereich von etwa -8·10⁻⁶ bis etwa -10·10⁻⁶, vorzugsweise im Bereich von etwa -8,5·10⁻⁶ bis etwa -9,5·10⁻⁶ umfasst.

3. Das optische Mikroskop nach Anspruch 2, wobei die Frontlinse (24) in einem vorderen Element (26) der Objektivlinsen-Anordnung (18) montiert ist, wobei das vordere Element (26) Material mit einer magnetischen Suszeptibilität im Bereich von etwa -8·10⁻⁶ bis etwa -10·10-⁶, besonders bevorzugt im Bereich von etwa -8,5·10⁻⁶ bis etwa -9,5·10⁻⁶ umfasst.

4. Das optische Mikroskop (10) nach irgendeinem der vorstehenden Ansprüche, wobei die Objektivlinsen-Anordnung (18) eine adaptive Linse (36) umfasst, wobei die optische Leistung der adaptiven Linse (36) über einen Piezoaktor variabel ist.

5. Das optische Mikroskop nach irgendeinem der vorhergehenden Ansprüche, wobei die Lichtweg-Ablenkanordnung ein oder mehrere Reflexionsprismen (38, 40, 42) umfasst, die die Lichtablenkung durch Totalreflexion bewirken, wobei die einen oder mehreren Reflexionsprismen (38, 40, 42) vorzugsweise ein erstes Reflexionsprisma (38), ein zweites Reflexionsprisma (40) und ein drittes Reflexionsprisma (42) umfassen.

6. Das optische Mikroskop nach irgendeinem der vorhergehenden Ansprüche, wobei die Beobachtungsoptik (54) ein Okular umfasst.

7. Das optische Mikroskop nach irgendeinem der vorhergehenden Ansprüche, wobei die Beobachtungsoptik (54) eine Kamera (48) und eine metallische Abschirmung (50, 52) umfasst, die die Kamera umgibt.

8. Das optische Mikroskop nach Anspruch 7, wobei die metallische Abschirmung einen Rohrabschnitt (52) umfasst, der sich im Wesentlichen entlang der zweiten optischen Achse (46) erstreckt, wobei der Rohrabschnitt (52) vorzugsweise die Beobachtungsoptik (54) zumindest teilweise aufnimmt.

9. Das optische Mikroskop nach irgendeinem der vorhergehenden Ansprüche, ferner umfassend eine vordere Beleuchtungseinheit zum Beleuchten der Probe durch die Objektivlinsen-Anordnung (18) und/oder eine hintere Beleuchtungseinheit zum Beleuchten der Probe von der Rückseite.

10. Das optische Mikroskop nach irgendeinem der vorhergehenden Ansprüche, wobei eine Mikrospule in einem Probenhalter implementiert ist, und wobei die Mikrospule und/oder der Probenhalter (16) vorzugsweise zum Empfangen von RF-Signalen von der Probe (14) geeignet sind/ist.

11. Ein Verfahren zur optischen Mikroskopie in einem MRT-Scanner, das Folgendes umfasst:
- Bereitstellen eines optischen Mikroskops (10) mit einer Objektivlinsen-Anordnung (18) zum Sammeln von Licht aus einer Probe (14), die innerhalb eines MRT-Scanners zu untersuchen ist, wobei die Objektivlinsen-Anordnung (18) eine erste optische Achse (20) aufweist, mit einer Beobachtungsoptik (54), die eine zweite optische Achse (46), senkrecht zur ersten optischen Achse (20) aufweist; mit einer Lichtweg-Ablenkanordnung (38, 40, 42) zum Umlenken von Licht ausgehend von der Objektivlinsen-Anordnung zur Beobachtungsoptik (54); wobei das optische Mikroskop (10) angepasst ist, um die in einer Objektebene des Mikroskops (10) befindliche Probe (14) zu beobachten, wobei die zweite optische Achse (46) nicht mehr als 20 mm von der Objektebene entfernt ist; und
- Anordnen des optischen Mikroskops innerhalb eines Magneten des MRT-Scanners mit der entlang einer Mittelachse des Magneten angeordneten Objektebene, mit der ersten optischen Achse im Wesentlichen senkrecht zur Mittelachse des Magneten und mit der zweiten optischen Achse im Wesentlichen parallel zur Mittelachse des Magneten und damit im Wesentlichen parallel zum Magnetfeld des Magneten.

12. Das Verfahren nach Anspruch 11, wobei ein indexangepasstes Material vorgesehen ist, um die Lücke zwischen der Probe und der Objektivlinsen-Anordnung zu füllen, wobei das indexangepasste Material eine magnetische Suszeptibilität aufweist, die von einer magnetischen Suszeptibilität der Probe um nicht mehr als etwa 1·10⁻⁶, vorzugsweise nicht mehr als etwa 0,5·10⁻⁶ abweicht.

13. Das Verfahren nach Anspruch 11 oder 12, ferner umfassend das Anordnen einer Frontlinse der Objektivlinsen-Anordnung (18) und einer Beleuchtungs-Frontlinse (34) symmetrisch auf beiden Seiten der Probe in Bezug auf eine Objektebene des optischen Mikroskops (10).

14. Das Verfahren nach irgendeinem der Ansprüche von 11 bis 13, ferner umfassend das magnetische Messen der Probe mit dem MRT-Scanner, während das optische Mikroskop innerhalb des Magneten positioniert ist.

15. Das Verfahren nach irgendeinem der Ansprüche von 11 bis 14, das eine lichtmikroskopische Aufnahme der Probe bei eingeschaltetem Magnetfeld des MRT-Scanners, vorzugsweise während einer MR-Messung, macht.

## Revendications

1. Un microscope optique (10) destiné à être utilisé dans un scanner d'imagerie par résonance magnétique (IRM), le microscope comprenant :
- un ensemble lentilles d'objectif (18) pour recueillir de la lumière à partir d'un échantillon (14) à étudier dans un scanner IRM, l'ensemble lentilles d'objectif (18) présentant un premier axe optique (20) ;
- une optique d'observation (54) présentant un deuxième axe optique (46) perpendiculaire au premier axe optique (20) ;
- un ensemble de déviation de trajet de lumière (38, 40, 42) pour dévier de la lumière de l'ensemble lentilles d'objectif vers l'optique d'observation (54) ;
sachant que le microscope optique (10) est adapté pour observer l'échantillon (14) situé dans un plan objet du microscope (10), sachant que le deuxième axe optique (46) n'est pas éloigné de plus de 20 mm du plan objet.

2. Le microscope optique d'après la revendication 1, sachant que l'ensemble lentilles d'objectif (18) comprend une lentille frontale (24) ayant une susceptibilité magnétique comprise entre environ -8.10⁻⁶ et environ -10·10⁻⁶, de préférence entre environ -8,5·10⁻⁶ et environ -9,5·10⁻⁶.

3. Le microscope optique d'après la revendication 2, sachant que la lentille frontale (24) est montée dans un élément frontal (26) de l'ensemble lentilles d'objectif (18), sachant que l'élément frontal (26) comprend un matériau ayant une susceptibilité magnétique comprise entre environ -8·10⁻⁶ et environ -10·10⁻⁶, de préférence entre environ -8,5·10⁻⁶ et environ -9,5·10⁻⁶.

4. Le microscope optique (10) d'après l'une quelconque des revendications précédentes, sachant que l'ensemble lentilles d'objectif (18) comprend une lentille adaptative (36), sachant que la puissance optique de la lentille adaptative (36) est variable au moyen d'un actionneur piézo.

5. Le microscope optique d'après l'une quelconque des revendications précédentes, sachant que l'ensemble de déviation de trajet de lumière comprend un ou plusieurs prismes de réflexion (38, 40, 42) qui effectuent la déviation de la lumière par réflexion totale, sachant que le ou les prismes de réflexion (38, 40, 42) comprennent de préférence un premier prisme de réflexion (38), un deuxième prisme de réflexion (40) et un troisième prisme de réflexion (42).

6. Le microscope optique d'après l'une quelconque des revendications précédentes, sachant que l'optique d'observation (54) comprend un oculaire.

7. Le microscope optique d'après l'une quelconque des revendications précédentes, sachant que l'optique d'observation (54) comprend une caméra (48) et un blindage métallique (50, 52) entourant la caméra.

8. Le microscope optique d'après la revendication 7, sachant que le blindage métallique comprend une partie tube (52) s'étendant essentiellement le long du deuxième axe optique (46), la partie tube (52) logeant de préférence au moins partiellement l'optique d'observation (54).

9. Le microscope optique d'après l'une quelconque des revendications précédentes, comprenant en outre une unité d'éclairage frontal pour éclairer l'échantillon à travers l'ensemble lentilles d'objectif (18) et/ou une unité d'éclairage arrière pour éclairer l'échantillon par l'arrière.

10. Le microscope optique d'après l'une quelconque des revendications précédentes, sachant qu'une micro-bobine est mise en oeuvre dans un porte-échantillon et sachant que la micro-bobine et/ou le porte-échantillon (16) est/sont de préférence adaptée(és) pour recevoir des signaux RF de l'échantillon (14).

11. Un procédé de microscopie optique à l'intérieur d'un scanner IRM comprenant le fait de
- fournir un microscope optique (10) avec un ensemble lentilles d'objectif (18) pour collecter la lumière d'un échantillon (14) à étudier à l'intérieur d'un scanner IRM, l'ensemble lentilles d'objectif (18) présentant un premier axe optique (20), avec une optique d'observation (54) présentant un deuxième axe optique (46) perpendiculaire au premier axe optique (20) ; avec un ensemble de déviation de trajet de lumière (38, 40, 42) pour dévier la lumière de l'ensemble lentilles d'objectif vers l'optique d'observation (54) ; sachant que le microscope optique (10) est adapté pour observer l'échantillon (14) situé dans un plan objet du microscope (10), et que le deuxième axe optique (46) n'est pas éloigné de plus de 20 mm du plan objet ; et de
- disposer le microscope optique à l'intérieur d'un aimant du scanner IRM, le plan objet étant disposé le long d'un axe central de l'aimant, le premier axe optique étant essentiellement perpendiculaire à l'axe central de l'aimant et le deuxième axe optique étant essentiellement parallèle à l'axe central de l'aimant, et donc essentiellement parallèle au champ magnétique de l'aimant.

12. Le procédé selon la revendication 11, sachant qu'un matériau à adaptation d'indice est fourni pour combler l'espace entre l'échantillon et l'ensemble lentilles d'objectif, sachant que le matériau à adaptation d'indice présente une susceptibilité magnétique qui s'écarte d'une susceptibilité magnétique de l'échantillon par pas plus de 1·10⁻⁶ environ, de préférence pas plus de 0,5·10⁻⁶ environ.

13. Le procédé selon la revendication 11 ou 12, comprenant en outre la disposition d'une lentille frontale de l'ensemble lentilles d'objectif (18) et d'une lentille frontale d'éclairage (34) symétriquement des deux côtés de l'échantillon par rapport à un plan objet du microscope optique (10).

14. Le procédé selon l'une quelconque des revendications 11 à 13, comprenant en outre la mesure magnétique de l'échantillon avec le scanner IRM alors que le microscope optique est positionné à l'intérieur de l'aimant.

15. Le procédé selon l'une quelconque des revendications 11 à 14, consistant à prendre une image microscopique optique de l'échantillon pendant que le champ magnétique du scanner IRM est activé, de préférence pendant une mesure par RM.
